# EUROPÄISCHE PATENTSCHRIFT

(11) **EP 3 850 352 B1**
(45) Veröffentlichungstag und Bekanntmachung des Hinweises auf die Patenterteilung: **02.10.2024**
(21) Anmeldenummer: 19765199.5
(22) Anmeldetag: 30.08.2019
(51) Int. Cl.: G01N 27/83

(54) **VORRICHTUNG UND VERFAHREN ZUR ZERSTÖRUNGSFREIEN PRÜFUNG VON BOLZENSCHWEISSVERBINDUNGEN**
DEVICE AND METHOD FOR THE NON-DESTRUCTIVE TESTING OF STUD WELDING CONNECTIONS
DISPOSITIF ET PROCÉDÉ D'ESSAI NON DESTRUCTIF DE JOINTS SOUDÉS PAR GOUJONS

(30) Priorität: 10.09.2018 DE 102018215327
(43) Veröffentlichungstag der Anmeldung: 21.07.2021
(73) Patentinhaber: EJOT SE & Co. KG, 57319 Bad Berleburg (DE)
(72) Erfinder: MATHISZIK, Christian, 01328 Dresden (DE); ZSCHETZSCHE, Jörg, 01129 Dresden (DE)
(74) Vertreter: Puschmann Borchert Kaiser Klettner Patentanwälte Partnerschaft mbB
(86) Internationale Anmeldenummer: PCT/EP2019/073190
(87) Internationale Veröffentlichungsnummer: WO 2020/052993

(56) Entgegenhaltungen:
- CN-A- 103 868 989
- CN-U- 203 011 890
- CN-U- 204 963 776
- US-A1- 2008 211 493

## Beschreibung

Es wird ein magnetisches Messverfahren und eine entsprechende Vorrichtung vorgeschlagen, welche für die einfache und zerstörungsfreie Prüfung von Bolzenschweißverbindungen optimiert ist.

Bolzenweißverbindungen dienen zur Befestigung von meist zylinderförmigen Bolzen auf Trägerplatten, die oftmals aus Blech gefertigt sind. Die Anwendungen sind vielfältig und finden sich insbesondere in Haushaltsgeräten, Kraftfahrzeugen, sowie im Stahl- und Anlagenbau.

Beispielsweise sind in einer Automobilkarosserie etwa 500 Bolzenschweißverbindungen verbaut. Auf Brückentragwerken werden typischerweise mehrere 10.000 Kopfbolzen eingesetzt.

Die Schweißverbindung zwischen Bolzen und Trägerplatte kann z.B. durch ein Laser- oder Plasmaschweißverfahren insbesondere mittels elektrischen Widerstandsschweißen hergestellt werden. Beim Verbinden eines Bolzens mit der Trägerplatte durch einen solchen Schweißprozess entstehen jedoch häufig Defekte, wie z.B. Risse oder Hohlräume, welche die Stabilität und Festigkeit der Verbindung stark beeinträchtigen können. Fehlerhafte Verbindungen werden oftmals erst während der Endmontage oder während des Betriebs festgestellt und müssen dann aufwändig nachgearbeitet werden.

Zur Prüfung einer Schweißverbindung können mechanische oder thermische Verfahren benutzt werden, die jedoch durch den Prüfprozess selbst die Stabilität der Verbindung beeinträchtigen können.

Zum Beispiel ist für eine Prüfung von Bolzenschweißverbindungen die Drehmomentprüfung bekannt, welche insbesondere bei Gewindebolzen als industrieller Maßstab eingesetzt wird. Durch die Drehmomentbeanspruchung der Bolzen kann aber eine Vorschädigung der Schweißverbindung erfolgen.

Bei thermischen Verfahren wird das Material der Schweißverbindung erhitzt und die danach entstehende Wärmeverteilung ortsaufgelöst gemessen. Hier kann eine zu starke Erhitzung zur Rissbildung beitragen. Außerdem ist ein solches Wärmetomographieverfahren sehr aufwändig und wird typischerweise in separaten Räumlichkeiten durchgeführt.

Eine Alternative bieten Röntgen-Computer-Tomographie Verfahren, die sowohl zeit- als auch kostenintensiv sind und daher typischerweise nur mit einer kleinen Stichprobe durchgeführt werden.

Hingegen sind einfache Sicht- oder Klangprüfungen oftmals nicht zuverlässig genug und lassen sich nur schwer automatisieren. Beide Prüfverfahren erfordern sehr viel Erfahrung des Prüfpersonals und sind auch von subjektiven Einschätzungen beeinflusst.

So betrifft CN 2049633776 U einen Wirbelstromsensor für den Einsatz an Schienenfahrzeugteilen.

Möglichkeiten für die Detektion von Defekten mit elektromagnetischen Mitteln an Schraubenlöchern sind in CN 203011890 U aufgezeigt.

Die Überprüfung von Nieten ist Gegenstand von US 2008/0211493 A1.

Eine Vorrichtung und ein Verfahren zur Überprüfung von Nietverbindungen an entsprechend verbundenen Metallplatten sind in CN 103868989 A beschreiben.

Es ist daher Aufgabe der Erfindung, eine möglichst einfache Vorrichtung und ein effizientes, zuverlässiges Verfahren zur zerstörungsfreien Prüfung von Bolzenschweißverbindungen vorzuschlagen.

Erfindungsgemäß wird diese Aufgabe mit einer Vorrichtung, welche die Merkmale des Anspruchs 1 aufweist, gelöst. Die Aufgabe kann mit dem in Anspruch 5 beschriebenen Verfahren gelöst werden. Vorteilhafte Ausgestaltungen und Weiterbildungen der Erfindung können mit den in den untergeordneten Ansprüchen bezeichneten Merkmalen realisiert werden.

Die Erfindung nutzt ein Magnetfeld welches die Schweißverbindung durchdringt, wobei eventuell vorhandene Defekte, die sich in der Schweißverbindung unterhalb und seitlich des Bolzens ausbilden, den Verlauf der magnetischen Feldlinien und damit die magnetische Flussdichte verändern. Durch Messung der magnetischen Flussdichte einer Probe und Vergleich mit mindestens einem Referenz- oder Kalibrierwert, der durch die Messung einer idealen Schweißverbindung ohne Defekte bestimmt wird, können dann fehlerhafte Verbindungen detektiert werden.

Für die Sensitivität und Zuverlässigkeit des Verfahrens ist es dabei von Bedeutung, dass zum einen der magnetische Fluss den Bolzen und die Schweißverbindung gut durchdringt und zum anderen die Magnetfeldsensoren, welche die Veränderung der magnetischen Flussdichte messen, möglichst nah an die Schweißverbindung heranreichend angeordnet sind.

Aus diesem Grund wird eine Vorrichtung vorgeschlagen, die sich der speziellen, oftmals zylinderförmigen Geometrie eines Bolzens so weit wie möglich anpasst. Dies wird erreicht indem ein Magnetjoch beispielsweise in Form eines Hohlzylinders ausgebildet ist, wobei der Innenradius des Hohlzylinders so gewählt ist, dass er nur minimal, bevorzugt ein paar Millimeter (maximal 3mm), grösser ist als der Außendurchmesser des Bolzen. Bei Bolzen mit einer polygonen oder anders geformten Grundfläche kann zur weiteren Optimierung auch ein Magnetjoch verwendet werden, welches einen Hohlraum mit einer entsprechend polygonen oder anders geformten Grundfläche aufweist. Der Hohlraum kann komplementär zur äußeren Kontur des Bolzens ausgebildet sein.

Eine oder mehrere Messungen erfolgen dann nachdem das Magnetjoch auf den Bolzen aufgesetzt oder der Bolzen in den Hohlraum des Magnetjochs eingeführt wurde.

Bei der Wahl der Innenmaße des Magnetjochs sollte berücksichtigt werden, dass bei Einführen des Bolzens in den Hohlraum des Magnetjochs noch mindestens eine Magnetfeldspule zwischen Bolzen und Magnetjoch passt. Eine solche Magnetfeldspule kann fest mit der Innenwand des Magnetjochs verbunden und an einen externen elektrischen Stromkreis angeschlossen sein. Insbesondere sollen Innendurchmesser und Höhe des Hohlraums so gewählt werden, dass der zu prüfende Bolzen vollständig in den Hohlraum einführbar ist.

Fließt ein elektrischer Strom durch die Magnetfeldspule bildet sich ein Magnetfeld aus, welches sowohl das Magnetjoch als auch den Bolzen und die Bolzenschweißverbindung durchsetzen soll. Voraussetzung dafür ist, dass der Bolzen weit genug in den Hohlzylinder hineinragt. Um dies zu gewährleisten, sollte das Magnetjoch mit einer Grundfläche auf der Trägerplatte aufliegen. Es kann aber auch ein kleiner Abstand von maximal 2 mm zwischen Magnetjoch und Trägerplatte, z.B. durch das Anbringen von Abstandshaltern, eingehalten werden.

Magnetfeldsensoren können auf einer ringförmigen Grundfläche des Magnetjochs aufliegen und z.B. durch eine Klebeverbindung befestigt sein. Sie können aber auch innenliegend an der Innenfläche oder außen an der Mantelfläche des Hohlzylinders angebracht sein. Mindesten zwei Magnetfeldsensoren sollten dabei auf einer ringförmigen Grundfläche an gegenüberliegenden Positionen angeordnet sein. Damit können Defekte die sich nicht zentral unter dem Bolzen befinden, sondern hauptsächlich an einer Seite der Schweißverbindung ausgeprägt sind, effizienter detektiert werden als wenn nur ein Magnetfeldsensor oder zwei direkt nebeneinander angeordnete Magnetfeldsensoren verwendet werden. Mehrere Magnetfeldsensoren sollten in jeweils gleichen Winkelabständen zueinander angeordnet sein.

Alternativ kann auch nur ein Magnetfeldsensor zum Einsatz kommen. Dieser sollte dann allerdings durch rotierende Bewegungen um den Bolzen herum geführt werden und so ortsaufgelöst mehrere Messwerte aufnehmen können. Zur Verbesserung der Messgenauigkeit können auch Messwerte von mehreren Magnetfeldsensoren an verschiedenen Positionen aufgenommen werden, wobei sich die verschiedenen Positionen durch translatorische oder rotierende Bewegungen des Magnetjochs um bzw. entlang der Längsachse des Bolzens ergeben.

Für eine ortsaufgelöste Spektroskopie kann die Trägerplatte mit einem Drehtisch verbunden sein, der an eine Motorsteuerung angeschlossen ist. Die Aufnahme einer Messkurve erfolgt dann durch mindestens eine 360 Grad Drehung des Drehtisches, wobei während der Drehung das Magnetjoch und der mindestens eine Magnetfeldsensor, der mit dem Magnetjoch verbunden ist, an derselben Stelle z.B. durch eine Aufhängung oder Halterung fix positioniert bleibt. Alternativ kann auch das Magnetjoch und damit auch der mindestens eine Magnetfeldsensor gedreht werden, während die Trägerplatte und der Bolzen fixiert bleiben. Eine Messkurve gibt dann die Winkelabhängigkeit der in mindestens einem Magnetfeldsensor gemessenen magnetischen Flussdichte wieder. Die Messkurve einer zu untersuchenden Probe kann mit der Messkurve einer den Qualitätsanforderungen genügenden Bolzenschweißverbindung verglichen werden.

Beispielsweise wird für jede Messkurve ein Mittelwert gebildet, der sich aus allen Messpunkten ergibt, die innerhalb eines Winkelbereichs von 360 Grad liegen. Zusätzlich wird für die Messkurve einer den Qualitätsanforderungen genügenden Bolzenschweißverbindung die typische Standardabweichung bestimmt. Weicht die Messkurve einer zu untersuchenden Probe in mindesten einem Winkelbereich um ein vorher festgelegtes Vielfaches der Standardabweichung vom Mittelwert der zu untersuchenden Probe ab, kann auf eine fehlerhafte Bolzenschweißverbindung der zu untersuchenden Probe geschlossen werden und der Defekt durch Angabe des entsprechenden Winkelbereichs lokalisiert werden.

Es können aber auch direkt Standardabweichungen oder höhere Momente der durch die Messpunkte innerhalb eines Winkelbereiches gegebenen Statistik miteinander verglichen werden.

Für eine Verbesserung der Messgenauigkeit können auch Mittelwerte und/oder Standardabweichungen von Messkurven mehrerer Proben und/oder mehrerer Magnetfeldsensoren kombiniert werden.

Bevorzugt werden Hallsensoren zur Messung eines statischen oder zeitlich veränderlichen Magnetfeldes eingesetzt. Es können aber auch Messspulen, magneto-resistive oder magneto-optische Sensoren benutzt werden.

Der Hohlzylinder kann auf einer Seite auch geschlossen sein, sodass das Magnetjoch aus einem einseitig offenen Hohlzylinder besteht und nur eine der beiden Grundflächen eine Öffnung aufweist. Die Höhe des Hohlzylinders sollte dann so gewählt werden, dass sie grösser als die maximale Höhe des Bolzens über der Trägerplatte ist. Die Magnetfeldsensoren sollten auf der Grundfläche angebracht sein, die eine Öffnung zum Einführen des Bolzens aufweist. Eine einseitig geschlossene Form des Hohlzylinders kann die magnetische Flussdichte im Bolzen und der Schweißverbindung zusätzlich erhöhen.

Durch die Optimierung der Designparameter aller Komponenten und eine vorteilhafte Positionierung der Vorrichtung in Bezug auf den zu prüfenden Bolzen samt Trägerplatte kann die Sensitivität des Messverfahrens verbessert werden. Beispielsweise kann das Magnetjoch von einem Roboterarm über den Bolzen geführt bzw. aufgesetzt werden, und z.B. eine Positionierung des Magnetjochs mittels Weg- und/oder Positionssensoren erfolgen. Eine Steuer- und Auswerteeinrichtung kann die von den Weg- und/oder Positionssensoren gemessenen Abstände zur Trägerplatte so regeln, dass der magnetische Fluss, der die Magnetfeldsensoren durchdringt, optimiert wird.

Eine Optimierung kann dadurch erreicht werden, dass Probemessungen an fehlerhaften Schweißverbindungen durchgeführt werden und die Position des Magnetjochs so gewählt wird, dass ein optimales Signal-Rausch Verhältnis erreicht wird bzw. die Abweichungen vom Referenzwert maximiert werden. Dabei können auch andere Parameter, wie zum Beispiel die an der Magnetfeldspule oder an den Hallsensoren angelegte elektrische Spannung, optimiert werden.

Das Messverfahren kann darin bestehen ein statisches Magnetfeld anzulegen und die an mindestens zwei Magnetfeldsensoren gemessenen magnetischen Flussdichten direkt mit Referenzwerten zu vergleichen. Eine fehlerhafte Verbindung zeichnet sich dann durch Abweichungen mindestens eines Messwertes oberhalb einer zuvor festgelegten Toleranz aus. Das statische Magnetfeld kann dabei durch die Wahl eines permanent magnetischen Magnetjochs oder durch Anlegen eines elektrischen Gleichstroms, der durch die Magnetfeldspule fließt, ausgebildet werden.

Durch Anlegen einer elektrischen Wechselspannung bildet die Magnetfeldspule ein zeitlich veränderliches Magnetfeld aus, welches in dem Bolzen und der Schweißverbindung elektrische Wirbelströme hervorruft. Diese Wirbelströme erzeugen wiederum ein Magnetfeld, welches dem ursprünglich angelegten Magnetfeld entgegenwirkt. Das effektiv resultierende Magnetfeld kann dann in den Magnetfeldsensoren gemessen und mit Referenzwerten verglichen werden.

Dabei ist zu beachten, dass induzierte elektrische Wirbelströme zu einer Erwärmung des Bolzens und der Bolzenschweißverbindung führen können, welche die Festigkeit der Verbindung beeinträchtigen. Um dennoch von einer zerstörungsfreien Prüfung sprechen zu können, sollten die angelegte elektrische Spannung und die Frequenz so gewählt werden, dass nur eine geringe Wärme erzeugt wird, ohne dass gleichzeitig die Sensitivität der Messmethode unter ein gewünschtes Niveau fällt.

Nachfolgend soll die Erfindung beispielhaft näher erläutert werden.

Dabei zeigen:
Figur 1 eine schematische Darstellung eines Beispiels einer erfindungsgemäßen Vorrichtung mit einer die Qualitätsanforderungen erfüllenden Bolzenschweißverbindung.
Figur 2 einen Schnitt durch Ebene A-A der Versuchsanordnung von Figur 1.
Figur 3 eine schematische Darstellung eines Beispiels einer erfindungsgemäßen Vorrichtung mit einer fehlerhaften Bolzenschweißverbindung.

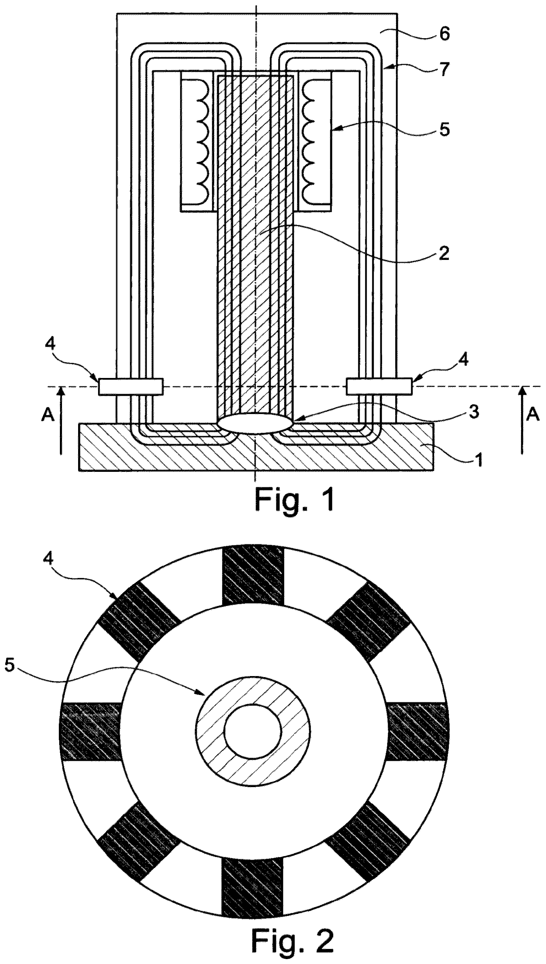

In Figur 1 ist ein Beispiel einer Vorrichtung zur zerstörungsfreien Prüfung einer Bolzenschweißverbindung 3 gezeigt. Ein Bolzen 2 ist durch eine Bolzenschweißverbindung 3 mit einer Trägerplatte 1 verbunden. Ein Magnetjoch 6, welches aus einem einseitig offenen Hohlzylinder besteht, ist auf den Bolzen 2 aufgesetzt. Magnetfeldsensoren 4 sind an einer Grundfläche des Magnetjochs 6 angebracht. Magnetfeldlinien eines Magnetfeldes 7, das mittels einer Magnetfeldspule 5 ausgebildet wird, durchdringen das Magnetjoch 6, den Bolzen 2, die Bolzenschweißverbindung 3 und die Magnetfeldsensoren 4. Die Wicklung der Magnetfeldspule 5 ist eng am Bolzen 2 angebracht, wobei der Abstand zwischen Magnetfeldspule 5 und Bolzen 2 weniger als 2 mm beträgt. Die Magnetfeldlinien 7 verlaufen symmetrisch bezüglich der Symmetrieachse des Hohlzylinders, so dass sich bei gleichem Abstand von der Symmetrieachse des Hohlzylinders stets dieselbe magnetische Flussdichte ergibt.

In Figur 2 ist eine beispielhafte Anordnung der Magnetisierungsspule 5 und von acht Magnetfeldsensoren 4 gezeigt, wobei die acht Magnetfeldsensoren 4 mit gleichen Winkelabständen zueinander in einer Ebene angeordnet sind.

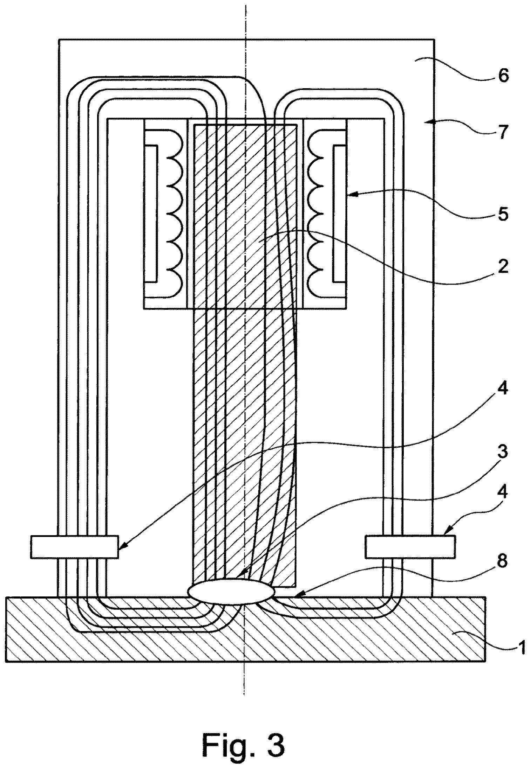

In Figur 3 ist ein Beispiel einer Vorrichtung zur zerstörungsfreien Prüfung einer fehlerhaften Bolzenschweißverbindung 3 mit Defekt 8 und gegenüber Figur 1 veränderten Magnetfeldlinien 7 gezeigt. Alle weiteren Elemente und deren Bezugszeichen stimmen mit Figur 1 überein.

Der Defekt 8 besteht in dem in Figur 3 gezeigten Beispiel aus einem Hohlraum, der zu einer unvollständig ausgebildeten Bolzenschweißverbindung 3 führt und dadurch die Festigkeit der Verbindung beeinträchtigen kann. Da der durch den Defekt 8 verursachende Hohlraum von keinen Magnetfeldlinien 7 durchdrungen wird, verlaufen die Magnetfeldlinien 7 asymmetrisch bezüglich der Symmetrieachse des Hohlzylinders. Diese Asymmetrie kann z.B. durch einen Vergleich der in den Magnetfeldsensoren 4, die links und rechts der Symmetrieachse angebracht sind, gemessenen magnetischen Flussdichten nachgewiesen werden. Ist die Differenz der magnetischen Flussdichten größer als ein zuvor festgelegter Toleranzwert, genügt die Bolzenschweißverbindung 3 nicht den Qualitätsanforderungen. Alternativ kann, wie bereits weiter oben näher beschrieben, auch die gesamte Winkelabhängigkeit der magnetischen Flussdichte durch Rotation der Trägerplatte 1 oder der Magnetfeldsensoren 4 bestimmt und zur Detektion des Defekts 8 benutzt werden. Die erfassten Messwerte der Magnetfeldsensoren 4 bilden eine Statistik ab, die mit einer Statistik, die sich aus den Messwerten einer den Qualitätsanforderungen genügenden Probe ergibt, verglichen werden kann. Zum Beispiel kann die Differenz aus den normierten Standardabweichungen beider Statistiken gebildet werden und falls diese Differenz größer als ein zuvor festgelegter Toleranzwert ist, kann auf eine fehlerhafte Bolzenschweißverbindung geschlossen werden. Alternative Kriterien zur Bestimmung einer fehlerhaften Bolzenschweißverbindung sind weiter oben näher beschrieben.

## Patentansprüche

1. Vorrichtung zur zerstörungsfreien Prüfung von Bolzenschweißverbindungen (3) bei der ein zylinderförmiger Bolzen (2) durch Schweißen mit einer Trägerplatte (1) verbunden ist,
bestehend aus einem Magnetjoch (6), mindestens einer Magnetfeldspule (5), und mindestens einem Magnetfeldsensor (4),
wobei
das Magnetjoch (6) einen Hohlraum aufweist, der aus einem offenen oder halboffenen Hohlzylinder gebildet ist, wobei der Innendurchmesser und die Höhe des Hohlzylinders so gewählt sind, dass der zu prüfende Bolzen (2) vollständig in den Hohlraum einführbar ist,
und
der mindestens eine Magnetfeldsensor (4) an der ringförmigen Grundfläche des Magnetjochs (6), welche eine Öffnung zum Hohlraum aufweist, oder an der inneren oder äußeren Mantelfläche angebracht ist
und
die mindestens eine Magnetfeldspule (5) in dem Hohlraum des Magnetjochs (6) so angeordnet ist, dass das von der Magnetfeldspule (5) ausgebildete Magnetfeld (7) das Magnetjoch (6), den Hohlraum des Magnetjochs (6) und den mindestens einen Magnetfeldsensor (4) durchdringt.

2. Vorrichtung nach Anspruch 1 **dadurch gekennzeichnet, dass** mehrere Magnetfeldsensoren (4) an verschiedenen Positionen und mit jeweils gleichen und bekannten Winkelabständen zueinander angeordnet sind.

3. Vorrichtung nach einem der vorigen Ansprüche **dadurch gekennzeichnet, dass** der mindestens eine Magnetfeldsensor (4) ein Hallsensor und/oder eine Messspule und/oder ein magneto-resistiver Sensor und/oder ein magneto-optischer Sensor ist.

4. Vorrichtung nach einem der vorigen Ansprüche **dadurch gekennzeichnet, dass** es sich bei dem Magnetjoch (6) um einen Permanentmagneten handelt.

5. Verfahren zur zerstörungsfreien Prüfung von Bolzenschweißverbindungen (3) mittels einer Vorrichtung nach einer der vorhergehenden Ansprüche **dadurch gekennzeichnet, dass**
- das Magnetjoch (6) auf den zu prüfenden mit der Trägerplatte (1) verschweißten Bolzen (2) aufgesetzt wird, wobei der Bolzen (2) in den Hohlraum des Hohlzylinders eingeführt wird
- die Magnetfeldspule (5) von einem elektrischen Strom durchflossen wird, der ein Magnetfeld (7) ausbildet, welches das Magnetjoch (6), den Bolzen (2), die Bolzenschweißverbindung (3) und den mindestens einen Magnetfeldsensor (4) durchdringt und
- die magnetische Flussdichte von dem mindestens einen Magnetfeldsensor (4) gemessen und mit Referenzwerten verglichen wird.

6. Verfahren nach dem vorigen Anspruch **dadurch gekennzeichnet, dass** das von der Magnetfeldspule (5) ausgebildete Magnetfeld (7) zeitlich veränderlich ist.

7. Verfahren nach einem der vorigen Ansprüche **dadurch gekennzeichnet, dass** zum Abgleichen mit einem Referenzwert mehrere Messergebnisse berücksichtigt werden, wobei
sich die mehreren Messergebnisse bei mindestens einer Rotation des mindestens einen Magnetfeldsensors (4), um die Längsachse des Magnetjochs (6) ergeben und sowohl nach als auch vor der mindestens einen Rotation gemessen wird
und/oder
sich die mehreren Messergebnisse aus mindestens einer translatorischen Bewegung des mindestens einen Magnetfeldsensors (4), entlang der Längsachse des Magnetjochs (6) ergeben und sowohl nach als auch vor der mindestens einen translatorischen Bewegung gemessen wird
und/oder
sich die mehreren Messergebnisse durch Messungen an mehreren Magnetfeldsensoren (4), die an verschiedenen Positionen des Magnetjochs (6) angebracht sind, erhalten werden.

## Claims

1. Device for the non-destructive testing of stud welding connections (3) in which a cylindrical stud (2) is connected to a carrier plate (1) by welding,
comprising a magnetic yoke (6), at least one magnetic field coil (5), and at least one magnetic field sensor (4),
wherein
the magnetic yoke (6) has a cavity which is formed from an open or semi-open hollow cylinder, with the inside diameter and the height of the hollow cylinder being selected such that the bolt (2) to be tested can be fully inserted into the cavity,
and
the at least one magnetic field sensor (4) is attached to the ring-shaped base of the magnet yoke (6), which has an opening to the cavity, or to the inner or outer lateral surface,
and
the at least one magnetic field coil (5) is arranged in the cavity of the magnetic yoke (6) in such a way that the magnetic field (7) generated by the magnetic field coil (5) penetrates the magnetic yoke (6), the cavity of the magnetic yoke (6) and the at least one magnetic field sensor (4).

2. Device according to claim 1, **characterized in that** a number of magnetic field sensors (4) are arranged at different positions and at equal and known angular distances from each other.

3. Device according to any one of the preceding claims, **characterized in that** the at least one magnetic field sensor (4) is a Hall effect sensor and/or a measuring coil and/or a magneto-resistive sensor and/or a magneto-optical sensor.

4. Device according to any one of the preceding claims, **characterized in that** the magnetic yoke (6) is a permanent magnet.

5. Method for the non-destructive testing of stud welding connections (3) by means of a device according to any one of the preceding claims, **characterized in that**
- the magnetic yoke (6) is placed on the bolt (2) to be tested, which latter is welded to the carrier plate (1), with the bolt (2) being inserted into the hollow space of the hollow cylinder;
- an electric current flows through the magnetic field coil (5), forming a magnetic field (7) which penetrates the magnetic yoke (6), the stud (2), the stud welding connection (3) and the at least one magnetic field sensor (4); and
- the magnetic flux density is measured by the at least one magnetic field sensor (4) and compared with reference values.

6. Method according to the preceding claim, **characterized in that** the magnetic field (7) generated by the magnetic field coil (5) is a time-varying magnetic field.

7. Method according to any one of the preceding claims, **characterized in that** a plurality of measurement results are taken into account for comparison with a reference value, wherein
the plurality of measurement results are obtained during at least one rotation of the at least one magnetic field sensor (4) about the longitudinal axis of the magnetic yoke (6), with measurements being taken both subsequent and prior to the at least one rotation,
and/or
the multiple measurement results are obtained from at least one translational movement of the at least one magnetic field sensor (4) along the longitudinal axis of the magnetic yoke (6), with measurements being taken both subsequent and prior to the at least one translational movement,
and/or
the multiple measurement results are obtained by measuring several magnetic field sensors (4), which are mounted in different positions on the magnetic yoke (6).

## Revendications

1. Dispositif de contrôle non destructif de liaisons par soudage de boulons (3) dans lequel un boulon de forme cylindrique (2) est relié à une plaque support (1) par soudage,
constitué d'une culasse magnétique (6), d'au moins une bobine à champ magnétique (5) et d'au moins un détecteur de champ magnétique (4),
dans lequel
la culasse magnétique (6) présente une cavité qui est formée à partir d'un cylindre creux ouvert ou semi-ouvert, où le diamètre interne et la hauteur du cylindre creux sont choisis de sorte que le boulon (2) à contrôler est entièrement insérable dans la cavité,
et
le au moins un détecteur de champ magnétique (4) est disposé sur la surface de base circulaire de la culasse magnétique (6), qui présente une ouverture vers la cavité, ou sur la surface de gaine interne ou externe,
et
la au moins une bobine à champ magnétique (5) dans la cavité de la culasse magnétique (6) est disposée de sorte que le champ magnétique (7) formé par la bobine à champ magnétique (5) traverse la culasse magnétique (6), la cavité de la culasse magnétique (6) et le au moins un détecteur de champ magnétique (4).

2. Dispositif selon la revendication 1, **caractérisé en ce que** plusieurs détecteurs de champ magnétique (4) sont disposés à différents endroits et avec des distances angulaires respectivement identiques et connues les uns par rapport aux autres.

3. Dispositif selon l'une des revendications précédentes, **caractérisé en ce que** le au moins un détecteur de champ magnétique (4) est un capteur à effet Hall et/ou une bobine de mesure et/ou un capteur magnéto-résistif et/ou un capteur magnéto-optique.

4. Dispositif selon l'une des revendications précédentes, **caractérisé en ce que** la culasse magnétique (6) est un aimant permanent.

5. Procédé de contrôle non destructif de liaisons par soudage de boulons (3) au moyen d'un dispositif selon l'une des revendications précédentes, **caractérisé en ce que**
- la culasse magnétique (6) est placée sur le boulon (2) à contrôler soudé à la plaque support (1), le boulon (2) étant inséré dans la cavité du cylindre creux
- la bobine à champ magnétique (5) est irriguée par un courant électrique qui forme un champ magnétique (7), qui traverse la culasse magnétique (6), le boulon (2), la liaison par soudage de boulons (2) et le au moins un détecteur de champ magnétique (4) et
- la densité de flux magnétique est mesurée par au moins un détecteur de champ magnétique (4) et comparée à des valeurs de référence.

6. Procédé selon la revendication précédente, **caractérisé en ce que** le champ magnétique (7) formé par la bobine à champ magnétique (5) est variable dans le temps.

7. Procédé selon l'une des revendications précédentes, **caractérisé en ce que** plusieurs résultats de mesure sont pris en compte pour la comparaison à une valeur de référence, où
les multiples résultats de mesure résultent lors d'au moins une rotation du au moins un détecteur de champ magnétique (4) autour de l'axe longitudinal de la culasse magnétique (6) et que la mesure s'effectue aussi bien après qu'avant la au moins une rotation
et/ou
les multiples résultats de mesure résultent d'au moins un mouvement de translation du au moins un détecteur de champ magnétique (4), le long de l'axe longitudinal de la culasse magnétique (6), et la mesure s'effectue aussi bien après qu'avant le au moins un mouvement de translation
et/ou
les multiples résultats de mesure sont obtenus par des mesures sur plusieurs détecteurs de champ magnétique (4), qui sont disposés à différents endroits de la culasse magnétique (6).
